(19) Europäisches Patentamt
European Patent Office
Office européen des brevets

(11) **EP 3 113 214 B1**

(12) **EUROPEAN PATENT SPECIFICATION**

(45) Date of publication and mention
of the grant of the patent:
**11.04.2018 Bulletin 2018/15**

(51) Int Cl.:
***H01L 21/66*** *(2006.01)*

(21) Application number: **16175208.4**

(22) Date of filing: **20.06.2016**

(54) **METHOD OF MANAGING DLTS MEASUREMENT APPARATUS**

VERFAHREN ZUR STEUERUNG EINER DLTS-MESSVORRICHTUNG

PROCÉDÉ DE GESTION D'APPAREIL DE MESURE DLTS

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **30.06.2015 JP 2015131179**

(43) Date of publication of application:
**04.01.2017 Bulletin 2017/01**

(73) Proprietor: **SUMCO CORPORATION**
**Tokyo 105-8634 (JP)**

(72) Inventors:
• **SASAKI, Syun**
**Tokyo 105-8634 (JP)**

• **ERIGUCHI, Kazutaka**
**Tokyo 105-8634 (JP)**

(74) Representative: **Sticht, Andreas**
**Kraus & Weisert**
**Patentanwälte PartGmbB**
**Thomas-Wimmer-Ring 15**
**80539 München (DE)**

(56) References cited:
**JP-A- 2013 187 510      JP-A- 2014 063 785**
**US-A1- 2002 008 534     US-A1- 2005 191 952**
**US-A1- 2007 205 788     US-A1- 2007 210 813**

**Description**

TECHNICAL FIELD

'The present invention relates to a method of managing a DLTS (Deep-Level Transient Spectroscopy) measurement apparatus and a DLTS measurement apparatus.

BACKGROUND ART

An evaluation method using a DLTS measurement apparatus (DLTS method) is known as an evaluation method of a semiconductor sample (refer to, for example, the following literatures 1 and 2).

> Literature 1: "Transient Capacitance Measurements on Resistive Samples" J. Appl. Phys 54 2907-2910 June 1983
> Literature 2: "Deep-level transient spectroscopy: A new method to characterize traps in semiconductors" J. Appl. Phys Vol/45, No. 7, 3023-3032 July 1974

US 2002/008534 A1 discloses a method as defined in the preamble of claim 1.
JP 2014/063785 A discloses a DLTS measurement on a sample which includes a semiconductor junction on one surface and an ohmic layer made of Ga on the back surface. JP 2013/187510 A discloses a performance check of used probe needles. If a control computer judges the degree of a probe needle degradation being too high, which means that the probe needle resistance exceeds an allowable value, the probe needle is exchanged.
US 2007/210813 A1 discloses a probe for electrical test and probe assembly, US 2005/0191952 A discloses a cleaning sheet for probe needles, and US 2007/0205788 A1 discloses a wafer holder and a wafer prober provided therewith.

SUMMARY OF THE INVENTION

A method as defined in claim 1 is provided. The dependent claims define further embodiments. According to the DLTS method, it is possible to evaluate the presence or absence of and the degree of metal contamination and/or crystal defects, by measuring a trap level in a semiconductor sample. Details are, for example, as follows. A diode is produced by forming a semiconductor junction (Schottky junction or pn-junction) on one surface of a semiconductor sample and forming an ohmic layer on the other surface, and transient change (transient response) ΔC, that is, DLTS signal intensity, in capacitance of this diode is measured when a voltage is periodically applied while temperature is swept. It is possible to identify contamination metal species from, for example, a peak position of a DLTS spectrum obtained by plotting the DLTS signal intensity with respect to temperature, and it is possible to perform quantitative evaluation of the metal contamination from the DLTS signal intensity at the peak position. Then, it becomes possible to perform various kinds of process control and quality control by utilizing an evaluation result like this. Examples include monitoring of cleanness within an epitaxial growth furnace as will be described in the following.

When atmosphere within the epitaxial growth furnace is contaminated with metal, metal is mixed into an epitaxial layer produced by performing vapor phase growth within the epitaxial growth furnace, from the atmosphere within the epitaxial growth furnace. Since the mixed metal amount tends to increase as the metal contamination in the epitaxial growth furnace is more serious, it is possible to evaluate the cleanness (the presence or absence and the degree of the metal contamination) in the epitaxial growth furnace by evaluating metal contamination in the epitaxial layer. Accordingly, it is possible to monitor the cleanness of the epitaxial growth furnace over a long period of time, for example, several months to several years, by periodically evaluating epitaxial layers produced in the same epitaxial growth furnace.

However, as a result of the research regarding the DLTS method by the present inventors, it has been found that there exists a case where, despite that a measurement result obtained by the DLTS method does not exhibit a large change, actually the cleanness of the epitaxial growth furnace considerably changes, and on the contrary, there exists a case where, despite that a measurement result obtained by the DLTS method exhibits a large change, actually the cleanness of the epitaxial growth furnace does not considerably change. The degradation of measurement accuracy like this becomes a cause of impairing the reliability of the process control by the monitoring of the cleanness in the epitaxial growth furnace.

Furthermore, enhancement of the measurement accuracy in the DLTS method is desired also for enhancing the reliability of various kinds of process control and/or quality control, without being limited to the cleanness monitoring of the epitaxial growth furnace. For example, it is possible to perform quality control of a semiconductor wafer by utilizing the measurement result of the DLTS measurement for quantification of metal contamination concentration of the semiconductor wafer such as a silicon wafer. However, when the metal contamination concentration obtained from the measurement result of the DLTS measurement is considerably different from actual metal contamination concentration, the reliability of the quality control deteriorates.

An object of the present invention is to provide a measure for improving the measurement accuracy of the DLTS method.

As a result of extensive research for achieving the above object, the present inventors have obtained conventionally and completely unknown novel finding that the chronological change of a sample stage and/or a wiring in the DLTS measurement apparatus and a difference between the apparatuses exert influences on the measurement result obtained by the DLTS method. The above literature 1, although the change of the DLTS signal has been studied, only gives the conclusion that the resistance in series of a measurement target sample exerts influence on the shape of a DLTS spectrum, and does not give any suggestion to the above finding the present inventors have newly found.

The present invention was devised on that basis.

An aspect of the present invention relates to:

A method of managing a DLTS measurement apparatus, wherein
the DLTS measurement apparatus includes:

a sample stage which has a measurement target sample placement surface and on which a measurement target sample having a semiconductor junction on one surface of a semiconductor sample and an ohmic layer on the other surface is placed in which the ohmic layer and the measurement target sample placement surface face each other;
a first wiring having a tip contacting (or being in contact) with the measurement target sample; and
a second wiring having a tip contacting (or being in contact) with the sample stage, and

the method including:

determining whether or not a measurement value measured by the DLTS measurement apparatus is in a preliminarily set allowable range; and
performing maintenance processing of exchanging or repairing at least one of a whole or a part of the sample stage, a whole or a part of the first wiring, and a whole or a part of the second wiring, in a case where the measurement value is outside the preliminarily set allowable range as a result of the determination.

In an embodiment, the maintenance processing can include exchange of a whole of the sample stage or a part of the sample stage including the measurement target sample placement surface.

The maintenance processing according to the present invention includes subjecting the measurement target sample placement surface of the sample stage to conductive covering film formation processing.

In an embodiment, the DLTS measurement apparatus is a DLTS measurement apparatus used for measuring a measurement target sample in which the ohmic layer includes Ga, and the covering film formation processing can form a covering film made of at least one metal selected from the group consisting of Au, Ag, and Pt, or a compound of the metal, on the measurement target sample placement surface of the sample stage.

In an embodiment, the covering film formation processing can be performed by vapor deposition.

In an embodiment, the maintenance processing can include polishing of at least a part of the sample stage.

In an embodiment, the maintenance processing can include exchange of the first wiring.

In an embodiment, the maintenance processing can include polishing of a part of the first wiring including the tip.

In an embodiment, the maintenance processing can include exchange of the second wiring.

In addition or alternatively to subjecting the measurement target sample placement surface to covering film formation processing, the maintenance processing according to the present invention includes subjecting a part of the second wiring including the tip to conductive covering film formation processing.

In an embodiment, the DLTS measurement apparatus is a DLTS measurement apparatus used for measuring a measurement target sample in which the ohmic layer includes Ga, and the covering film formation processing can form a covering film made of at least one metal selected from the group consisting of Au, Ag, and Pt, or a compound of the metal, on a part of the second wiring including the tip.

In an embodiment, the covering film formation processing can be performed by vapor deposition.

In an embodiment, the measurement value can be at least one measurement value selected from the group consisting of a capacitance, a resistance value and a DLTS signal intensity.

A further aspect of the present disclosure not forming part of the claimed invention relates to:

A DLTS measurement apparatus including:

a sample stage which has a measurement target sample placement surface and on which a measurement target sample having a semiconductor junction on one surface of a semiconductor sample and an ohmic layer on the other surface is placed in which the ohmic layer and the measurement target sample placement surface face each other;
a first wiring having a tip contacting or being in contact with the measurement target sample; and
a second wiring having a tip contacting or being in contact with the sample stage, and

the DLTS measurement apparatus is a DLTS measurement apparatus used for measuring a measurement target sample in which the ohmic layer includes Ga, wherein

at least one of the measurement target sample placement surface of the sample stage and the tip of the second wiring has a covering film made of at least one metal selected from the group consisting of Au, Ag, and Pt or a compound of the metal.

The covering film can be an vapor-deposited film made of at least one metal selected from the group consisting of Au, Ag, and Pt, or a compound of the metal.

According to an aspect of the present invention, it is possible to prevent the influence of the DLTS measurement apparatus on the measurement result by the DLTS method, or to reduce influence of the measurement apparatus.

BRIEF DESCRIPTION OF THE DRAWINGS

FIG 1 is a schematic configuration diagram illustrating an example of a sample placement section in a DLTS measurement apparatus.

FIG. 2 shows a state where a measurement target sample (diode) is placed on the sample placement section in the DLTS measurement apparatus shown in FIG. 1.

FIG. 3 is a schematic configuration diagram illustrating an example of a sample placement section in a DLTS measurement apparatus.

FIG. 4 shows a state where measurement target samples (diodes) are placed on the sample placement section in the DLTS measurement apparatus shown in FIG. 3.

FIG. 5 shows DLTS measurement results obtained before and after maintenance processing in Example.

FIG. 6 shows DLTS measurement results obtained before and after maintenance processing in Example.

FIG. 7 shows a measurement result (capacitance and resistance value) related with study on covering film formation and maintenance processing described below.

DESCRIPTION OF EMBODIMENTS

[Management method of a DLTS measurement apparatus]

An aspect of the present invention relates to a method of managing a DLTS measurement apparatus (hereinafter, also referred to simply as "management method") as set out in claim 1, using a DLTS measurement apparatus as set out in claim 1. The above management method will be further explained in detail below.

<Configuration of the DLTS measurement apparatus>

The DLTS measurement apparatus managed by the above management method includes at least a sample stage having a measurement target sample placement surface (hereinafter, also referred to as "placement surface") on which a measurement target sample is placed, a first wiring having a tip contacting or being in contact with the measurement target sample, and a second wiring having a tip contacting or being in contact with the sample stage. The measurement target sample which has a semiconductor junction (Schottky junction or pn-junction) formed on one surface of a semiconductor sample and an ohmic layer formed on the other surface is disposed on the placement surface of the sample stage so as to cause the semiconductor junction to be positioned on the upper side and to cause the ohmic layer to be positioned on the lower side, that is, to cause the ohmic layer and the placement surface to face each other. In a state where the tip of the first wiring contacts with the surface of the semiconductor junction and also the tip of the second wiring contacts with the sample stage, it is possible to evaluate the presence or absence and/or the degree of the metal contamination and the crystal defects in the measurement target sample through the DLTS method as set forth above by periodically applying a voltage while sweeping temperature.

A specific embodiment of a configuration for the DLTS measurement apparatus will be described below on the basis of the drawings. However, the specific embodiment shown below is exemplification, and the present invention is not limited to the following specific embodiment.

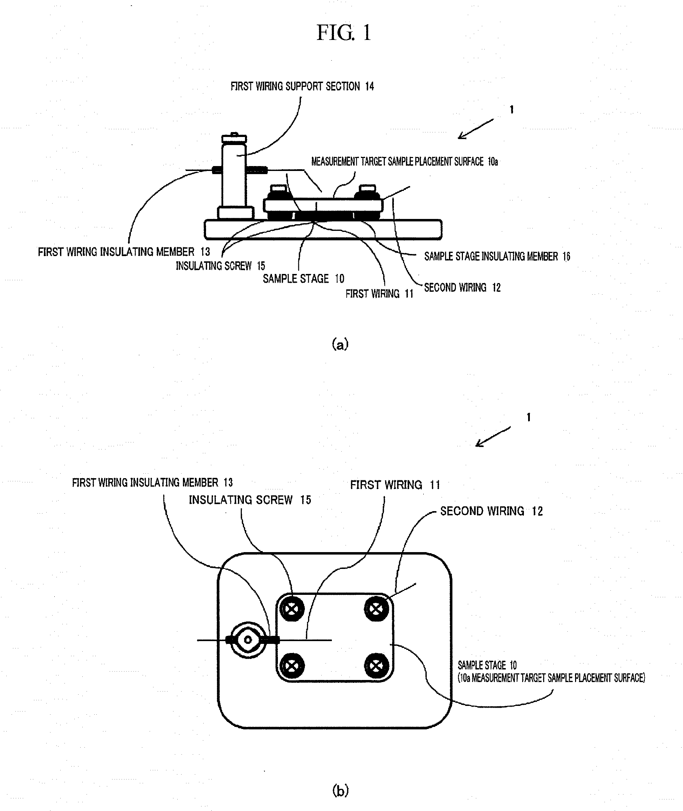

FIG 1 is a schematic configuration diagram illustrating an example of a sample placement section in the DLTS measurement apparatus, and FIG. 1(a) is a side view and FIG. 1(b) is a plan view. The sample placement section 1 of the DLTS measurement apparatus shown in FIG. 1 is provided with a sample stage 10, a first wiring 11, and a second wiring 12, and furthermore provided with a first wiring insulating member 13, a first wiring support section 14, an insulating screw 15, and a sample stage insulating member 16.

At least a measurement target sample placement surface (placement surface) 10a of the sample stage 10 is constituted of a conductive material so as to be able to apply voltage to a measurement target sample (in more detail, diode which has a semiconductor junction and an ohmic layer formed on a semiconductor sample; the same in the following) via the first wiring and the second wiring. A known conductive material such as a metal or an alloy can be used as such a material. Furthermore, the whole sample stage 10 may be constituted of a conductive material such as a metal or an alloy, and the whole surface including the placement surface 10a may be constituted of a conductive material such as a metal or an alloy.

The sample stage 10 is fixed by the insulating screws 15 at four points, and is electrically separated from the earth by the insulating screws 15 and the sample stage insulating member 16.

The first wiring insulating member 13, the insulating screw 15, and the sample stage insulating member 16 explained above are constituted of known insulating materials.

The tip of the first wiring 11 contacts with the measurement target sample at the time of DLTS measurement, and specifically, contacts with the semiconductor junction formed on the measurement target sample. The first wiring 11 can be a wiring usually used in the DLTS measurement apparatus, such as a wiring in which an insulating material covers the surface of a conductive material. It is possible to apply a voltage to the measurement target sample by exposing the conductive material at least at the tip. The above matter regarding the wiring is the same as in the case of the second wiring.

The first wiring 11 is supported by a first wiring support section 14, and electrically separated from the first wiring support section by the first wiring insulating member 13. The first wiring support section 14 includes a movable mechanism (not illustrated); and can cause the tip of the first wiring 11 to contact with the measurement target sample or can release the contact, by movably supporting the first wiring and moving the first wiring 11 at least up and down.

The tip of the second wiring 12 contacts with the sample stage 10 of the DLTS measurement apparatus at the time of the DLTS measurement, and specifically, contacts with a section constituted of a conductive material in the sample stage 10. The first wiring 11 contacts with the semiconductor junction formed in the measurement target sample and the second wiring 12 contacts with the section constituted of the conductive material in the sample stage 10 on which the measurement target sample is disposed, and thus it is possible to apply a voltage to the measurement target sample. Although the second wiring 12 contacts with the placement surface 10a in an embodiment shown in FIG. 1, the second wiring 12 may contact with the section constituted of the conductive material in the sample stage 10 as described above, and is not limited to the embodiment shown in FIG. 1. The second wiring 12 can apply a voltage to the measurement target sample by exposure of the conductive material at least from the tip thereof.

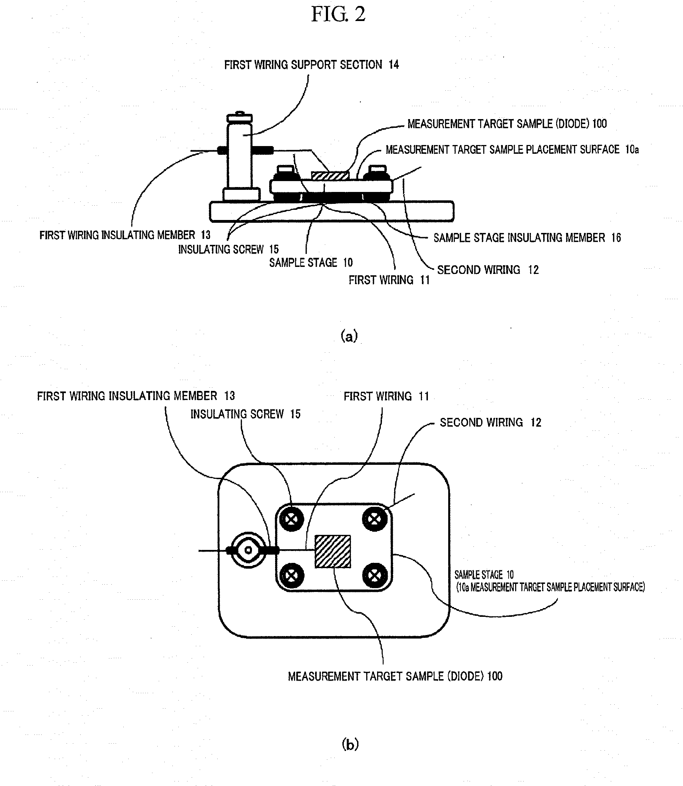

FIG. 2 shows a state where the measurement target sample (diode) 100 is placed on the sample placement section 1 of the DLTS measurement apparatus shown in FIG. 1. In this way, a voltage can be applied to the measurement target sample 100 via the first wiring 11 and the second wiring 12.

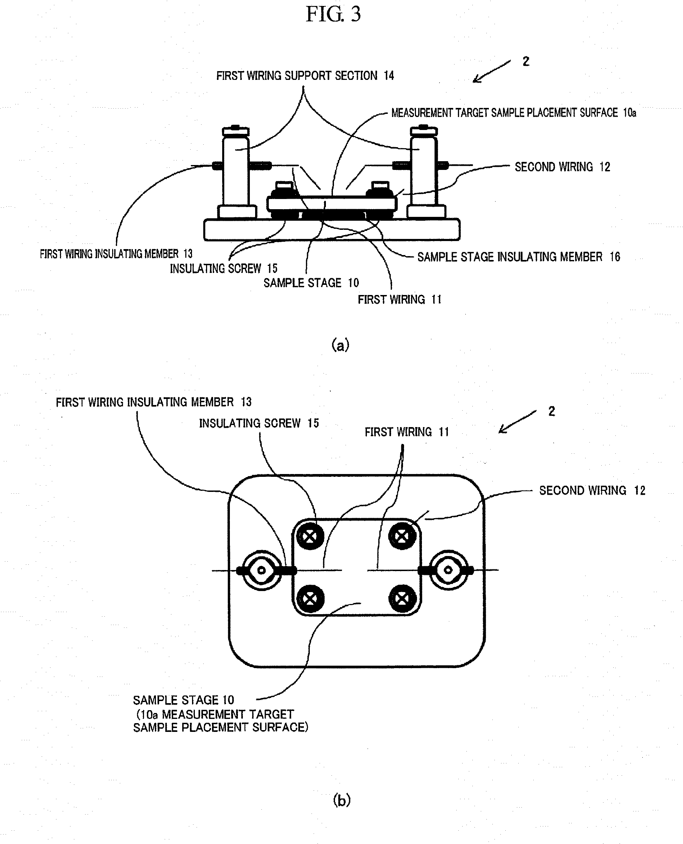

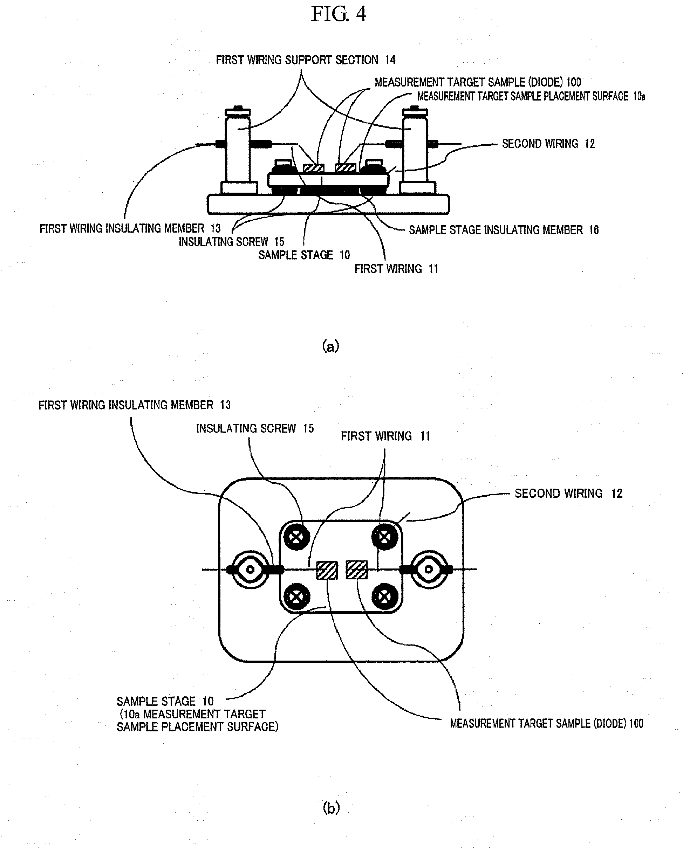

Although one measurement target sample 100 is placed on the sample stage of the DLTS measurement apparatus in the embodiment explained above, two or more samples can be placed and the number of measurement target samples placed is not specifically limited. Furthermore, each of the number of first wirings and the number of the second wirings can also be equal to two or more than two in accordance with the number of measurement target samples and the numbers of these wirings are not also specifically limited. As an example, FIG. 3 shows a schematic configuration diagram illustrating an example of a preferable sample placement section of a DLTS measurement apparatus for performing the DLTS measurement by placement of two measurement target samples. FIG. 4 shows a state where two measurement target samples (diodes) 100 are placed on the sample placement section 2 of the DLTS measurement apparatus shown in FIG. 3. The DLTS measurement apparatus shown in FIGS. 3 and 4 has the same configuration as the DLTS measurement apparatus shown in FIGS. 1 and 2 except that two first wirings are provided and the first wiring support section 14 including the first wiring insulating member 13 is provided for each of the wirings. When two or more measurement target samples are placed on the sample stage, it is not necessary to provide the first wiring for each of the measurement target samples, and it is possible to apply a voltage sequentially to each of the measurement target samples by the single first wiring. The first wiring support section 14 can have a movable mechanism therefor (not illustrated).

<Production of the measurement target sample>

The measurement target sample can be produced by forming a semiconductor junction (Schottky junction or pn-junction) on one surface of a semiconductor sample and forming an ohmic layer on the other surface. Examples of the semiconductor sample can include, for example, various kinds of semiconductor substrates such as a silicon single-crystal wafer and a silicon epitaxial wafer; a semiconductor sample partially cut out therefrom; and the like. A known technique can be applied to the formation of each of the semiconductor junction and the ohmic layer.

<Detection of abnormal values>

Regarding the DLTS measurement, as described above, the present inventors have obtained conventionally completely unknown novel findings in which the following factors sometimes cause an abnormal value and lower measurement accuracy in the DLTS measurement.

- Chronological change of the sample stage
- Chronological change of the wiring
- Difference in the sample stage among a plurality of apparatuses
- Difference in the wiring among a plurality of apparatuses

Accordingly, in order to detect an abnormal value caused by such factors, a management method of the present invention preliminarily sets an allowable range for a measurement value, and determines whether or not a measured measurement value is in this allowable range. An embodiment of such determination includes preparing a reference sample, and determining that maintenance is not necessary when an obtained value is included in the allowable range as a result of the DLTS measurement under the same condition using the reference sample and determining that the maintenance is necessary when the obtained value is outside the allowable range. The allowable range may be optionally set in consideration of quality or the like required for a product, and is not specifically limited. For example, as an example, in the measurement of the reference sample for setting the allowable range, the DLTS measurement is performed in a plurality of times by applying a voltage to the same reference sample from each of a plurality of first wirings in the DLTS measurement apparatus including the plurality of first wirings, the standard deviation σ of a plurality of measurement values obtained by the measurement in the plurality of times is calculated, and the allowable range can be determined by using this standard deviation σ as an index. Alternatively, in the measurement of the reference sample for setting the allowable range, the DLTS measurement while applying a voltage from one first wiring is performed in a plurality of times, a standard deviation σ of a plurality of measurement values obtained by the plurality of measurement is calculated, and the allowable range can be obtained by using this standard deviation σ as an index. In each of the above embodiments, also in consideration of a variation that can be usually caused as a measurement error, an average value ± 3σ of the above measurement value in the plurality of times can be set to be the allowable range, and in a case where the measurement value exceeds the above average value ± 3σ, it is preferably determined that the measurement value is an abnormal value and the maintenance is necessary. As a measurement value used in such determination, at least one measurement value selected from the group consisting of a capacitance, a resistance value, and a DLTS signal intensity which are obtained by the DLTS measurement is preferably used.

<Maintenance processing>

In the management method of the present invention, maintenance processing is performed when an abnormal value is detected as a result of the above explained determination. The maintenance processing is performed by at least one method of the following methods (1) to (3).

(1) Exchange or repair of the whole or a part of the sample stage
(2) Exchange or repair of the whole or a part of the first wiring
(3) Exchange or repair of the whole or a part of the second wiring

The above maintenance processing has not been performed conventionally in the technical field of the DLTS measurement, and the necessity thereof has been newly found as a result of the extensive research by the present inventors.
A specific embodiment of the maintenance processing will be further explained below.

(1) Exchange or repair of the sample stage

The present inventors presume that the deterioration of the sample stage is one factor that causes a measurement value obtained by the DLTS measurement to become an abnormal value. The deterioration of the sample stage includes: a physical damage (scratch) caused by vibration in the placement of the measurement target sample or during the measurement; and a quality change of the placement surface (for example, oxidation (for example, metal rust), erosion, or the like). In order to prevent the generation of an abnormal value by such deterioration, an embodiment includes exchange of the whole or a part of the measurement stage. Examples of a part that tends to deteriorate include the placement surface where the measurement target sample is placed, and thus only a part of the sample stage including the placement surface may be exchanged.
Furthermore, the maintenance processing includes covering film formation processing of forming a covering film on the placement surface. This is because conductivity lowering caused by deterioration of the placement surface can be a factor that causes an abnormal value. In consideration of being hard to cause deterioration such as oxidation and erosion, of having conductivity (preferably high electrical conductivity), and the like, examples of a preferable covering film can include a covering film made of metals such as Au, Ag, Pt, Pd, Rh, Ir, Ru, and Os, or a metal compound containing at least one of these metals; and a covering film made of a metal selected from the group consisting of Au, Ag, and Pt and a metal compound containing at last one of these metals is more preferable. Examples of the metal compound include, for example, metal nitride, metal carbide, and the like, and also include an alloy. The formation of the covering film can be performed by a known film formation method such as a vapor deposition method and a sputtering method, and preferably performed by the vapor deposition method. The thickness of the covering film to be formed is, for example, approximately 0.1 to 1 μm, and is not limited to this range.
An embodiment of the ohmic layer formed on the measurement target sample can include an ohmic layer containing Ga. Examples of the ohmic layer like this include a gallium (Ga) layer, for example, a Ga layer formed by rubbing or vapor deposition of Ga. It has been found that, when an ohmic layer like this is placed on the placement surface of the sample stage directly or indirectly via a known conductive sheet, the placement surface tends to deteriorate. While the reason is not clear, the present inventors presume that the cause will be the quality change of the placement surface caused by elution of Ga. From the viewpoint of suppressing such deterioration, a covering film made of the above metal or a metal compound containing at least one of these metals is preferably formed on the placement surface, and a covering film made of a metal selected from the group consisting of Au, Ag, and Pt or a metal compound containing at least one of these metals is more preferably formed.

Furthermore, an embodiment of the sample stage repair can also include polishing of at least a part of the sample stage. This is because the removal of a deteriorated part by polishing is assumed to be effective in suppressing the abnormal value generation. Moreover, the above covering film formation processing can also be performed after the polishing. The polishing is assumed to be also effective in enhancing the adhesiveness of the covering film. The polishing can be performed by a known polishing method. The removal amount by the polishing is not specifically limited, and may be optionally determined in accordance with the degree of the quality change or the like.

(2) Exchange or repair of the whole or a part of the first wiring

The present inventors also presume the deterioration of the first wiring as a factor that causes the measurement value obtained by the DLTS measurement to become an abnormal value. The deterioration of the first wiring includes damage (wiring breakage or the like) in a part of the wiring, and quality change at least at a part (e.g., oxidation (metal rust or the like), erosion, or the like). In one embodiment, the prevention of the generation of an abnormal value by such deterioration includes exchange of the first wiring.

Examples of a part that tends to deteriorate, in particular, a part that tends to have a quality change in the first wiring include the tip of the first wiring. This is because it is assumed that the exposure of the conductive material at the tip of the first wiring, the contact with a measurement target sample (in detail, semiconductor junction surface of the measurement target sample), and the like can be a factor that causes the quality change. Accordingly, examples of repair of the first wiring include being able to polishing a part of the first wiring including the tip. This is because the removal of a deteriorated part by polishing is assumed to be effective in suppressing the generation of an abnormal value.

(3) Exchange or repair of the whole or a part of the second wiring

The present inventors also presume the deterioration of the second wiring as a factor that causes the measurement value obtained by the DLTS measurement to become an abnormal value. The deterioration of the second wiring includes damage (wiring breakage or the like) in a part of the wiring, and quality change at least at a part (e.g., oxidation (metal rust or the like), erosion, or the like). In one embodiment, the prevention of the generation of an abnormal value by such deterioration includes exchange of the second wiring.

Examples of a part that tends to deteriorate in the second wiring, in particular, a part that tends to have a quality change include the tip of the second wiring. This is because it is assumed that the exposure of the conductive material at the tip of the second wiring, contact with the placement surface, and the like can be a factor that causes the quality change. Accordingly, examples of repair of the second wiring include being able to polishing a part of the second wiring including the tip. This is because the removal of a deteriorated part by polishing is assumed to be effective in suppressing the generation of an abnormal value.

Furthermore, the maintenance processing also includes subjecting a part of the second wiring including the tip to covering film formation processing. As to a material used for the covering film formation processing and a covering film formation method, it is possible to refer to the above description regarding the covering film which can be formed on the placement surface of the sample stage.

An embodiment of the ohmic layer formed on the measurement target sample can include the ohmic layer containing Ga as described above. It has been found as a result of the extensive research by the present inventors that the tip of the second wiring contacted with the placement surface of the sample stage on which the ohmic layer like this is placed directly or indirectly via the known conductive sheet tends to deteriorate. Although the reason is not clear, the present inventors presume that this is also caused by the elution of Ga. From the viewpoint of suppressing such deterioration, a covering film made of the above metal or the metal compound containing at least one of these metals is preferably formed on a part of the second wiring including the tip, and more preferably, a covering film made of a metal selected from the group consisting of Au, Ag, and Pt or a metal compound containing at least one of these metals is formed. As explained above with regard to the repair of the placement surface of the sample stage, it is possible to perform the covering film formation processing after the polishing.

The above covering film formation processing described for the second wiring can be also performed on the first wiring.

In the management method of the present invention, at least any one kind of the above maintenance processing can be performed in a case where an abnormal value is detected. It may or may not be necessary to identify a section where deterioration being a factor of causing an abnormal value is generated. In a preferable embodiment, it is possible to confirm that a factor causing an abnormal value has been removed or reduced by the maintenance processing, by performing the DLTS measurement after the maintenance processing in the DLTS measurement apparatus on which the maintenance processing was performed and by confirming that a measurement value within a preliminarily set allowable range is obtained. Furthermore, in a case where an abnormal value is also detected after the maintenance processing as the result of the DLTS measurement performed in the DLTS measurement apparatus on which the maintenance processing was performed, an additional maintenance processing (re-maintenance processing) is preferably performed. The re-maintenance processing can be the same kind of processing as the maintenance processing performed earlier, or can be a different kind of maintenance processing. Then, it is possible to confirm that a factor causing an abnormal value has been removed or reduced by the re-maintenance processing, by performing the DLTS measurement after the re-maintenance processing in the DLTS measurement apparatus for which the re-maintenance processing was performed and by confirming that a measurement value within the preliminarily set allowable range is obtained. In a case where an abnormal value is further detected, it is possible to perform additional maintenance processing, preferably, maintenance processing which has not been performed so far, and preferably it is also possible to perform an operation of confirming that a factor causing the abnormal value has been removed or reduced by such maintenance processing. It is preferable to confirm that a factor causing an abnormal value has been removed or reduced by the maintenance processing in this way, in order to further enhance measurement accuracy.

By performing the above-explained management method of the present invention, it is possible to prevent the DLTS measurement apparatus from exerting an influence on a measurement result by the DLTS method, or to reduce the influence exerted by the DLTS measurement apparatus. In this way, it is possible to increase the measurement accuracy of the DLTS measurement and to enhance measurement reliability.

[DLTS measurement apparatus]

A further aspect of the present disclosure not forming part of the claimed invention relates to:

A DLTS measurement apparatus including:

a sample stage which has a measurement target sample placement surface and on which a measurement target sample having a semiconductor junction on one surface of a semiconductor sample and an ohmic layer on the other surface is placed in which the ohmic layer and the measurement target sample placement surface face each other;
a first wiring having a tip contacting or being in contact with the measurement target sample;
and
a second wiring having a tip contacting or being in contact with the sample stage, and

the DLTS measurement apparatus is a DLTS measurement apparatus used for measuring a measurement target sample in which the ohmic layer includes Ga, wherein
at least one of the measurement target sample placement surface of the sample stage and the tip of the second wiring has a covering film made of at least one metal selected from the group consisting of Au, Ag, and Pt or a compound of the metal.

As described above, it has been found as a result of the research by the present inventors that, in a case where the DLTS measurement is performed on a measurement target sample having the ohmic layer containing Ga, the placement surface of the sample stage for a DLTS measurement target sample and/or the tip of the second wiring tend to deteriorate. In contrast, the above DLTS measurement apparatus has the covering film made of at least one metal selected from the group consisting of Au, Ag, and Pt or a compound of the metal at, at least, one of the measurement target sample placement surface of the sample stage and the tip of the second wiring. Since Au, Ag, and Pt are assumed to be preferable metals from the viewpoint of being hardly deteriorated by Ga, the present inventors presume that the deterioration of the placement surface of the sample stage and/or the tip of the second wiring can be prevented by provision of a covering film made of such a metal or compound. Details of the covering film are as explained above.

Except for the matters explained above, the DLTS measurement in the present invention can be performed by a known method. As to details of the measurement, it is possible to refer to, for example, the above literature 2 ("Deep-level transient spectroscopy: A new method to characterize traps in semiconductors" J. Appl. Phys (Vol/45, No. 7, 3023-3032 July 1974). From a measurement value by the DLTS measurement, it is possible to evaluate, for example, the presence or absence and the degree of the metal contamination and the crystal defects in a semiconductor sample. The evaluation result can be used for various kinds of process control and quality control such as the above-described monitoring of the cleanness in the epitaxial growth furnace.

EXAMPLES

The present invention will be further explained below on the basis of Examples. However, the present invention is not limited to embodiments to be shown in Examples.

1. DLTS measurement of measurement target sample including Au-contaminated semiconductor sample

(1) Sample production

A plurality of phosphor (P)-doped n-type silicon wafers within the same product lot was intentionally subjected to Au contamination in the same known concentration, and then a part was cut out from each of the silicon wafers and a semiconductor sample was prepared.

The following (A), (B), and (C) were performed for each of the above semiconductor samples, and thus a measurement target sample having a Schottky junction on one surface in each of the semiconductor samples and an ohmic layer (Ga layer) on the other surface was obtained.

(A) Oxide film removal by HF aqueous solution + pure water rinsing + drying
(B) Schottky electrode formation by vacuum vapor deposition (electrode area: 1 mm$^2$)
(C) Rear surface ohmic contact formation by gallium rubbing

(2) DLTS measurement before the maintenance processing

DLTS measurement was performed for one of the measurement target samples produced in the above (1) using a DLTS measurement apparatus which had been used for several years from the start of the use. The schematic configuration of a sample placement section in the DLTS measurement apparatus used is as explained above with reference to the drawings. The measurement was performed as follows.

1) A reverse direction voltage ($V_R$) that forms a depletion layer and a pulse voltage (V) for capturing a carrier into the depletion layer were applied alternately and periodically to the Schottky junction of the measurement target sample.
2) A transient response of the capacitance of a diode, generated corresponding to the voltage, was measured.
3) The voltage application and the capacitance measurement of above 1) and 2) were performed while sample temperature is swept in a predetermined temperature range. DLTS signal intensities ΔC were plotted with respect to the temperature and a DLTS spectrum was obtained.

(3) DLTS measurement after the maintenance processing

After the DLTS measurement of above (2), an Au film having a thickness of 0.6 μm was formed on the measurement target sample placement surface of the sample stage of the above DLTS measurement apparatus as the maintenance processing, by vacuum vapor deposition after polishing with an emery paper.

The DLTS measurement was performed for one of the measurement target samples produced in the above (1) in the same way as in the above (2), after the maintenance processing.

(4) Study on DLTS signal change by the maintenance processing

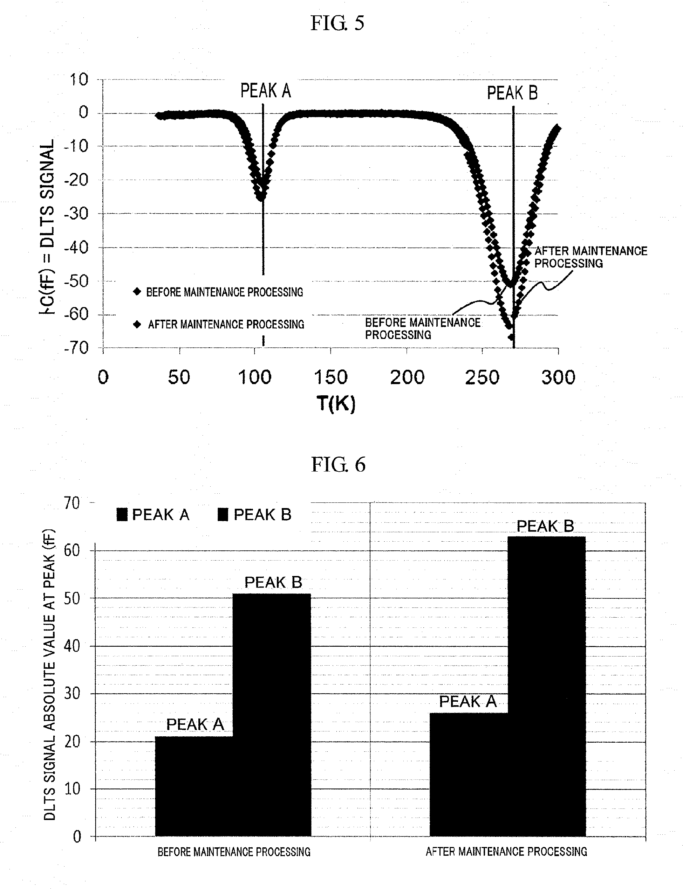

DLTS spectra obtained in the above measurement of (2) and (3) are shown in FIG. 5.

In FIG. 5, both of peak A and peak B are peaks indicating the existence of Au.

FIG. 6 shows DLTS signal intensities (absolute values) at peaks A and B in the DLTS spectra obtained in the above measurement (2) and (3).

From the result shown in FIGS. 5 and 6, the DLTS signal intensity before the maintenance processing was smaller than the DLTS signal intensity after the maintenance processing, at each of peak A and peak B.

Furthermore, the DLTS signal intensity (ΔC) is usually defined as follows.

$$\Delta C = C\,(t1) - C\,(t2) \cdots (1)$$

In the above formula (1), C (t1) denotes a capacitance at time t1 when a predetermined time passes after the voltage application, and C(t2) denotes a capacitance at time t2 when a predetermined time passes after the measurement of C(t1). When a deep level exists in the depletion layer formed by the reverse direction voltage ($V_R$) application, a DLTS spectrum as shown in FIG. 5 is obtained by plotting the DLTS signal intensity ΔC in relation to temperature. The reason why the spectrum having a shape as shown in FIG. 5 is obtained is because the speed of carrier emission depends on temperature as follows.

Low temperature: Since carrier emission from a deep level is slow, ΔC ≈ 0 holds.

High temperature: The carrier emission from a deep level is fast and the carrier emission is almost completed before t = t1, and as a result, ΔC ≈ 0 holds.

From such a relationship, a ΔC peak appears at a predetermined temperature depending on the property of a deep level (activation energy Ea and carrier capturing cross-sectional area σ) and a measurement condition. Although the DLTS spectrum shown in FIG. 5 has a peak in the downward direction (convex downward) because of the data processing according to above formula (1), there is a case where the data processing is performed by ΔC = C (t2) - C (t1), and in this case, the signal from a deep level becomes convex upward.

From the above, it is possible to calculate the concentration ($N_T$) of the deep levels, that is, metal contamination intensity by following formula (2) from the DLTS signal intensity (absolute value) at a peak position in the DLTS spectrum.

$$N_T \approx 2 \times N_D \times \Delta C_{MAX}/C_\infty \; (/cm^3) \cdots (2)$$

In the above formula, $N_D$ expresses a dopant concentration, $\Delta C_{MAX}$ expresses a DLTS signal intensity at a peak position, and $C_\infty$ expresses a depletion layer capacitance after the carrier emission from a deep level is almost finished following the $V_R$ application. Therefore, $C_\infty = C(V=VR, t = \infty)$ holds.

When an Au contamination concentration was calculated by the above formula (2) from each of the DLTS spectra shown in FIG. 5, the Au contamination concentration calculated from the DLTS spectrum before the maintenance processing was lower than the known contamination intensity although the Au contamination intensity calculated from the DLTS spectrum after the maintenance processing had a value similar to a known contamination intensity.

The present inventors presume that the above result indicates that the Au contamination concentration obtained from the measurement result of the DLTS measurement was calculated to be lower than an actual contamination concentration by the deterioration of the DLTS measurement apparatus (sample placement surface of the sample placing stage) caused by the use for many years in the above example, and the Au contamination concentration similar to the actual contamination concentration was able to be obtained by the DLTS measurement after the maintenance processing and the measurement accuracy was able to be enhanced.

Since the above DLTS measurement apparatus has been used for several years for measuring measurement target samples each having an ohmic layer containing Ga, the inventors presume that the quality change by Ga is a factor that causes the above deterioration of the sample placement surface.

2. Study on the covering film formation and the maintenance processing

(1) Evaluation target DLTS apparatus

As to two DLTS measurement apparatuses, one DLTS measurement apparatus (hereinafter, described as "apparatus A"), in which polishing and Au vapor deposition were performed on the sample placement surface as in the above 1.(3), and the other DLTS measurement apparatus (hereinafter, described as "apparatus B"), in which the above polishing and Au vapor deposition were not performed, were used continuously for one month at the same use frequency and under the same use condition. Each of measurement target samples measured was a sample having an ohmic layer containing Ga.

(2) Reference sample preparation and allowable range setting

A plurality of measurement target samples was produced as reference samples in the same method as in the above 1.(1) by using a plurality of phosphor (P)-doped n-type silicon wafers within the same product lot.

The DLTS measurement was performed as in the above 1.(2) by using the apparatus A immediately after the above polishing and Au vapor deposition for the above plurality of reference samples, and capacitances and resistance values were obtained. The standard deviation σ was calculated for the measurement values of the reference samples, and an average value ± 3σ of the above measurement values was set as the allowable range.

(3) Study on chronological deterioration prevention by the covering film processing

The DLTS measurement was performed in the same way as in the above 1.(2) by using the reference samples produced in the above (2) and by using each of the above apparatus A and apparatus B in the above (1) after one month use, and thus capacitances and resistance values were obtained. As a result, the capacitances and resistance values obtained by the DLTS measurement using the apparatus A were in the allowable range set in the above (2). On the other hand, both the capacitances and resistance values obtained by the DLTS measurement using the apparatus B were outside the allowable range set in the above (2).

(4) Study on the maintenance processing

After the measurement in the above (3), the apparatus A was not subjected to the maintenance processing and the apparatus B was subjected to the polishing of the sample placement surface as the maintenance processing in the same way as in the above 1.(3) (however, without the Au vapor deposition). After that, the DLTS measurement was performed on the reference samples by using the apparatuses A and B at the same frequency as in the above 1.(2).

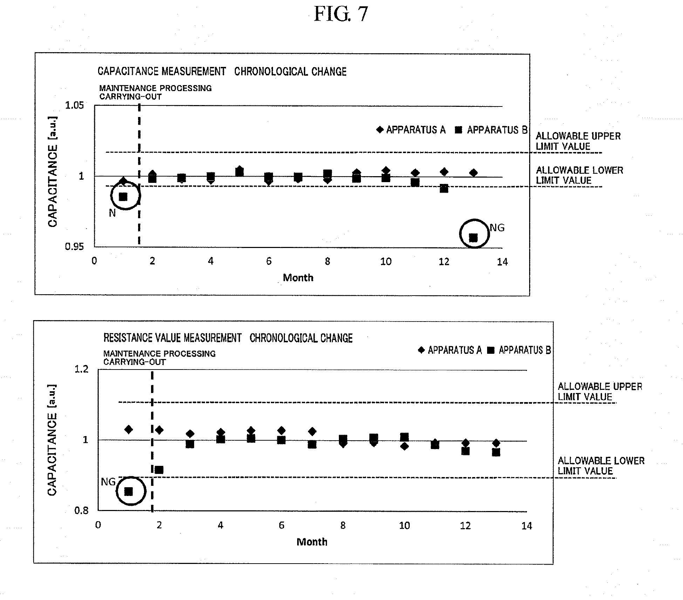

Capacitances and resistance values obtained in the above are shown in FIG. 7 together with the measurement values obtained in the above (3).

From the result shown in FIG. 7, it can be confirmed that, in the case of the apparatus B, measurement values (capacitances and resistance values) within the above set allowance range were obtained by the maintenance processing. Regarding the capacitance, although a measurement result outside the allowance range was obtained again after 13 months, a measurement value within the allowance range can be obtained by performing the maintenance processing again.

The present inventors presume the results of the above (3) and (4) as follows.

1) The present inventors presume that the results of the above (3) and (4) indicate that the chronological deterioration of the sample placement surface caused by the DLTS measurement of a measurement target sample having the ohmic layer containing Ga was able to be suppressed by the formation of the Au vapor deposition film (covering film) on the sample placement surface in the apparatus A. It is assumed that the same effect can be obtained also by using Ag or Pt which is a metal hardly deteriorated by Ga as Au. Furthermore, it is assumed that it is possible to suppress deterioration by forming a covering film similarly, also regarding the second wiring which can be deteriorated by the ohmic layer containing Ga.

2) The present inventors presume that the result of above (4) indicates that a part deteriorated (quality-changed) by the influence of Ga was removed by the polishing of the sample placement surface as the maintenance processing and thus the measurement values by the DLTS measurement was in the allowable rang.

The above is exemplification, and according to the present invention, the measurement accuracy of the DLTS measurement can be enhanced by carrying out the above various kinds of maintenance processing.

The present invention can be useful for the quality control and the manufacturing process control of a semiconductor wafer.

**Claims**

1. A method of managing a DLTS measurement apparatus, wherein
the DLTS measurement apparatus comprises:

a sample stage (10) which has a measurement target sample placement surface (10a) and on which a measurement target sample (100) is placed;
a first wiring (11) having a tip contacting or being in contact with the measurement target sample (100);
**characterized in that**
the target sample has a semiconductor junction on one surface of a semiconductor sample and an ohmic layer on the other surface and is placed such that the ohmic layer and the measurement target sample placement surface face each other, **in that**
the DLTS measurement apparatus comprises a second wiring (12) having a tip contacting or being in contact with the sample stage (10); and **in that**

the method comprises:

determining whether or not a measurement value measured by the DLTS measurement apparatus is in a preliminarily set allowable range; and
performing maintenance processing of exchanging or repairing at least one of a whole or a part of the sample stage (10), a whole or a part of the first wiring (11), and a whole or a part of the second wiring (12), in a case where the measurement value is outside the preliminarily set allowable range as a result of the determination, wherein the maintenance processing comprises subjecting the measurement target sample placement surface (10a) of the sample stage (10) and/or a part of the second wiring (12) including the tip to conductive covering film formation processing.

2. The method of managing according to claim 1, wherein in the case of not subjecting the measurement target sample placement surface of the sample stage, but a part of the second wiring including the tip to conductive covering film formation processing, the maintenance processing comprises exchange of a whole of the sample stage or a part of the sample stage including the measurement target sample placement surface.

3. The method of managing according to claim 1, wherein
the DLTS measurement apparatus is a DLTS measurement apparatus used for measuring a measurement target sample in which the ohmic layer includes Ga, and
the covering film formation processing forms a covering film made of at least one metal selected from the group consisting of Au, Ag, and Pt, or a compound of the metal.

4. The method of managing according to claim 1, wherein
the covering film formation processing is performed by vapor deposition.

5. The method of managing according to any of claims 1 to 4, wherein
the maintenance processing comprises polishing of at least a part of the sample stage (10).

6. The method of managing according to any of claims 1 to 5, wherein
the maintenance processing comprises exchange of the first wiring (11).

7. The method of managing according to any of claims 1 to 5, wherein
the maintenance processing comprises polishing of a part of the first wiring (11) including the tip.

8. The method of managing according to any of claims 1 to 7, wherein in the case of not subjecting a part of the second wiring including the tip, but the measurement target sample placement surface of the sample stage to conductive covering film formation processing, the maintenance processing comprises exchange of the second wiring (12).

9. The method of managing according to any of claims 1 to 8, wherein
the measurement value is at least one measurement value selected from the group consisting of a capacitance, a resistance value and a DLTS signal intensity.


**Patentansprüche**

1. Verfahren zur Handhabung einer DLTS-Messvorrichtung, wobei die DLTS-Messvorrichtung umfasst:

   einen Probentisch (10), welcher eine Messzielprobenplatzierungsoberfläche (10a) aufweist und auf welchem eine Messzielprobe (100) platziert wird,
   eine erste Verdrahtung (11) mit einer Spitze, welche die Messzielprobe (100) kontaktiert oder mit ihr in Kontakt steht,
   **dadurch gekennzeichnet, dass**
   die Zielprobe einen Halbleiterübergang auf einer Oberfläche einer Halbleiterprobe und eine ohmsche Schicht auf der anderen Oberfläche aufweist und derart platziert ist, dass die ohmsche Schicht und die Messzielprobenplatzierungsoberfläche einander zugewandt sind, dass
   die DLTS-Messvorrichtung eine zweite Verdrahtung (12) mit einer Spitze, welche den Probentisch (10) kontaktiert oder mit ihm in Kontakt steht, umfasst, und dass
   das Verfahren umfasst:

   Bestimmen, ob ein durch die Messvorrichtung gemessener Messwert in einem vorläufig festgelegten erlaubten Bereich ist oder nicht,
   Durchführung einer Wartungsarbeit des Austauschens oder Reparieren von zumindest einem des gesamten oder eines Teils des Probentisches (10), der gesamten oder eines Teils der ersten Verdrahtung (11) und der gesamten oder eines Teils der zweiten Verdrahtung (12) in einem Fall, in dem der Messwert außerhalb des vorläufig festgelegten erlaubten Bereiches ist als Ergebnis der Bestimmung, wobei die Wartungsarbeit umfasst, die Messzielprobenplatzierungsoberfläche (10a) des Probentisches (10) und/oder einen Teil der zweiten Verdrahtung (12) einschließlich der Spitze einer eine leitende Abdeckschicht bildenden Prozessierung zu unterziehen.

2. Verfahren zur Handhabung nach Anspruch 1, wobei in dem Fall, in dem die Messzielprobenplatzierungsoberfläche des Probentisches, nicht aber ein Teil der zweiten Verdrahtung einschließlich der Spitze der eine leitende Abdeckschicht bildenden Prozessierung unterzogen wird, die Wartungsarbeit einen Austausch des gesamten Probentisches oder eines Teils des Probentisches einschließlich der Messzielprobenplatzierungsoberfläche umfasst.

3. Verfahren zur Handhabung nach Anspruch 1, wobei die DLTS-Messvorrichtung eine DLTS-Messvorrichtung ist, die benutzt wird, um eine Messzielprobe zu messen, bei der die ohmsche Schicht Ga enthält, und die eine Abdeckschicht bildende Prozessierung eine Abdeckschicht ausbildet, die aus zumindest einem Metall gewählt aus der Gruppe bestehend aus Au, Ag und Pt oder eine Zusammensetzung des Metalls gefertigt ist.

4. Verfahren zur Handhabung gemäß Anspruch 1, wobei die eine Abdeckschicht bildende Prozessierung durch Gasphasenabscheidung durchgeführt wird.

5. Verfahren zur Handhabung gemäß einem der Ansprüche 1-4, wobei die Wartungsarbeit ein Polieren von zumindest einem Teil des Probentisches (10) umfasst.

6. Verfahren zur Handhabung gemäß einem der Ansprüche 1-5, wobei die Wartungsarbeit ein Austauschen der ersten Verdrahtung (11) umfasst.

7. Verfahren zur Handhabung gemäß einem der Ansprüche 1-5, wobei die Wartungsarbeit ein Polieren eines Teils der ersten Verdrahtung (11) einschließlich der Spitze umfasst.

8. Verfahren zur Handhabung gemäß einem der Ansprüche 1-7, wobei in dem Fall, in dem die zweite Verdrahtung einschließlich der Spitze nicht, aber die Messzielprobenplatzierungsoberfläche des Probentisches der eine leitende Abdeckschicht bildenden Prozessierung unterzogen wird, die Wartungsarbeiten einen Austausch der zweiten Verdrahtung (12) umfassen.

9. Verfahren zur Handhabung gemäß einem der Ansprüche 1-8, wobei der Messwert mindestens ein Messwert ausgewählt aus der Gruppe bestehend aus einer Kapazität, einem Widerstandswert und einer DLTS-Signalintensität ist.

## Revendications

1. Procédé de gestion d'un appareil de mesure DLTS, dans lequel
   l'appareil de mesure DLTS comprend :

   un étage d'échantillon (10) qui a une surface de placement d'échantillon cible de mesure (10a) et sur lequel est placé un échantillon cible de mesure (100) ;
   un premier câblage (11) ayant une pointe venant en contact ou étant en contact avec l'échantillon cible de mesure (100) ;
   **caractérisé en ce que**
   l'échantillon cible a une jonction de semiconducteur sur une surface d'un échantillon de semiconducteur et une couche ohmique sur l'autre surface et est placé de sorte que la couche ohmique et la surface de placement d'échantillon cible de mesure soient en regard l'une de l'autre,
   **en ce que**
   l'appareil de mesure DLTS comprend un second câblage (12) ayant une pointe venant en contact ou étant en contact avec l'étage d'échantillon (10) ; et **en ce que**
   le procédé comprend :

   le fait de déterminer si une valeur de mesure mesurée par l'appareil de mesure DLTS est ou non dans une plage admissible fixée au préalable ; et
   la réalisation d'un traitement de maintenance d'échange ou de réparation d'au moins l'un d'une totalité ou d'une partie de l'étage d'échantillon (10), d'une totalité ou d'une partie du premier câblage (11), et d'une totalité ou d'une partie du second câblage (12), dans un cas où la valeur de mesure est à l'extérieur de la plage admissible fixée au préalable suite à la détermination, dans lequel le traitement de maintenance comprend le fait de soumettre la surface de placement d'échantillon cible de mesure (10a) de l'étage d'échantillon (10) et/ou une partie du second câblage (12) comportant la pointe à un traitement de formation de film de revêtement conducteur.

2. Procédé de gestion selon la revendication 1, dans lequel
   dans le cas où la surface de placement d'échantillon cible de mesure de l'étage d'échantillon n'est pas soumise à un traitement de formation de film de revêtement conducteur, mais qu'une partie du second câblage comportant la pointe l'est,
le traitement de maintenance comprend l'échange d'une totalité de l'étage d'échantillon ou d'une partie de l'étage d'échantillon comportant la surface de placement d'échantillon cible de mesure.

3. Procédé de gestion selon la revendication 1, dans lequel
   l'appareil de mesure DLTS est un appareil de mesure DLTS utilisé pour mesurer un échantillon cible de mesure dans lequel la couche ohmique comporte du Ga, et
   le traitement de formation de film de revêtement forme un film de revêtement composé d'au moins un métal choisi dans le groupe constitué d'Au, d'Ag, et de Pt, ou d'un composé du métal.

4. Procédé de gestion selon la revendication 1, dans lequel
   le traitement de formation de film de revêtement est réalisé par dépôt en phase vapeur.

5. Procédé de gestion selon l'une quelconque des revendications 1 à 4, dans lequel
   le traitement de maintenance comprend le polissage d'au moins une partie de l'étage d'échantillon (10).

6. Procédé de gestion selon l'une quelconque des revendications 1 à 5, dans lequel
   le traitement de maintenance comprend l'échange du premier câblage (11).

7. Procédé de gestion selon l'une quelconque des revendications 1 à 5, dans lequel
   le traitement de maintenance comprend le polissage d'une partie du premier câblage (11) comportant la pointe.

8. Procédé de gestion selon l'une quelconque des revendications 1 à 7, dans lequel
   dans le cas où une partie du second câblage comportant la pointe n'est pas soumise à un traitement de formation de film de revêtement conducteur, mais que la surface de placement d'échantillon cible de mesure de l'étage d'échantillon l'est,
   le traitement de maintenance comprend l'échange du second câblage (12).

9. Procédé de gestion selon l'une quelconque des revendications 1 à 8, dans lequel
   la valeur de mesure est au moins une valeur de mesure choisie dans le groupe constitué d'une capacité, d'une valeur de résistance et d'une intensité de signal DLTS.

# FIG. 1

FIRST WIRING SUPPORT SECTION 14

MEASUREMENT TARGET SAMPLE PLACEMENT SURFACE 10a

1

FIRST WIRING INSULATING MEMBER 13

INSULATING SCREW 15

SAMPLE STAGE 10

FIRST WIRING 11

SECOND WIRING 12

SAMPLE STAGE INSULATING MEMBER 16

(a)

1

FIRST WIRING INSULATING MEMBER 13

INSULATING SCREW 15

FIRST WIRING 11

SECOND WIRING 12

SAMPLE STAGE 10
(10a MEASUREMENT TARGET SAMPLE PLACEMENT SURFACE)

(b)

# FIG. 2

FIRST WIRING SUPPORT SECTION 14

MEASUREMENT TARGET SAMPLE (DIODE) 100

MEASUREMENT TARGET SAMPLE PLACEMENT SURFACE 10a

FIRST WIRING INSULATING MEMBER 13

INSULATING SCREW 15

SAMPLE STAGE 10

FIRST WIRING 11

SAMPLE STAGE INSULATING MEMBER 16

SECOND WIRING 12

(a)

FIRST WIRING INSULATING MEMBER 13

INSULATING SCREW 15

FIRST WIRING 11

SECOND WIRING 12

SAMPLE STAGE 10
(10a MEASUREMENT TARGET SAMPLE PLACEMENT SURFACE)

MEASUREMENT TARGET SAMPLE (DIODE) 100

(b)

15

EP 3 113 214 B1

FIG. 3

FIRST WIRING SUPPORT SECTION 14

MEASUREMENT TARGET SAMPLE PLACEMENT SURFACE 10a

SECOND WIRING 12

FIRST WIRING INSULATING MEMBER 13

INSULATING SCREW 15

SAMPLE STAGE 10

FIRST WIRING 11

SAMPLE STAGE INSULATING MEMBER 16

(a)

FIRST WIRING INSULATING MEMBER 13

INSULATING SCREW 15

FIRST WIRING 11

SECOND WIRING 12

SAMPLE STAGE 10
(10a MEASUREMENT TARGET
SAMPLE PLACEMENT SURFACE)

(b)

16

# FIG. 4

FIRST WIRING SUPPORT SECTION 14

MEASUREMENT TARGET SAMPLE (DIODE) 100

MEASUREMENT TARGET SAMPLE PLACEMENT SURFACE 10a

SECOND WIRING 12

FIRST WIRING INSULATING MEMBER 13

SAMPLE STAGE INSULATING MEMBER 16

INSULATING SCREW 15

SAMPLE STAGE 10

FIRST WIRING 11

(a)

FIRST WIRING INSULATING MEMBER 13

INSULATING SCREW 15

FIRST WIRING 11

SECOND WIRING 12

SAMPLE STAGE 10
(10a MEASUREMENT TARGET
SAMPLE PLACEMENT SURFACE)

MEASUREMENT TARGET SAMPLE (DIODE) 100

(b)

17

FIG. 5

FIG. 6

## FIG. 7

CAPACITANCE MEASUREMENT   CHRONOLOGICAL CHANGE

MAINTENANCE PROCESSING
CARRYING-OUT

◆ APPARATUS A   ■ APPARATUS B

ALLOWABLE UPPER
LIMIT VALUE

ALLOWABLE LOWER
LIMIT VALUE

CAPACITANCE [a.u.]

N

NG

Month

RESISTANCE VALUE MEASUREMENT   CHRONOLOGICAL CHANGE

◆ APPARATUS A   ■ APPARATUS B

MAINTENANCE PROCESSING
CARRYING-OUT

ALLOWABLE UPPER
LIMIT VALUE

ALLOWABLE LOWER
LIMIT VALUE

CAPACITANCE [a.u.]

NG

Month

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2002008534 A1
- JP 2014063785 A
- JP 2013187510 A
- US 2007210813 A1
- US 20050191952 A
- US 20070205788 A1

### Non-patent literature cited in the description

- Transient Capacitance Measurements on Resistive Samples. *J. Appl. Phys,* June 1983, vol. 54, 2907-2910
- Deep-level transient spectroscopy: A new method to characterize traps in semiconductors. *J. Appl. Phys,* July 1974, vol. 45 (7), 3023-3032